# EUROPEAN PATENT APPLICATION

(11) **EP 3 330 313 A1**
(43) Date of publication of application: **06.06.2018**
(21) Application number: 16830210.7
(22) Date of filing: 23.06.2016
(51) Int. Cl.: C08J 9/14, B32B 5/18, B32B 15/082, H05K 1/03

(54) **FLUORORESIN POROUS BODY, METAL LAYER-EQUIPPED POROUS BODY USING SAME, AND WIRING SUBSTRATE**

(30) Priority: 29.07.2015 JP 2015150077
(71) Applicant: Nitto Denko Corporation, Ibaraki-shi, Osaka 567-8680 (JP)
(72) Inventor: KASAGI Tomoyuki, Ibaraki-shi Osaka 567-8680 (JP); KITAGAWA Yuya, Ibaraki-shi Osaka 567-8680 (JP)
(74) Representative: Grünecker Patent- und Rechtsanwälte PartG mbB
(86) International application number: PCT/JP2016/068593
(87) International publication number: WO 2017/018105

(57) **Abstract**

To obtain a fluororesin porous body serving as a material achieving both an excellent low specific dielectric constant and an excellent low linear expansion coefficient, which has heretofore been difficult to obtain, and a metal layer-equipped porous body and a wiring substrate each using the fluororesin porous body, provided is a fluororesin porous body including a fluororesin matrix and hollow inorganic particles dispersed in the fluororesin matrix, in which the fluororesin matrix has a large number of pores.

## Description

### TECHNICAL FIELD

The present disclosure relates to a fluororesin porous body serving as a material achieving both an excellent low specific dielectric constant and an excellent low linear expansion coefficient, which has heretofore been difficult to obtain, and to a metal layer-equipped porous body and a wiring substrate each using the fluororesin porous body.

### BACKGROUND ART

Due to advance of electronic technology, electronic devices, such as computers and mobile communication devices, each using the high frequency band are increasing . For a wiring substrate for high frequency applications to be used for such electronic device, a material having a low specific dielectric constant is generally required. As a resin material having a low specific dielectric constant, there are given, for example, nonpolar polymer resin materials, such as polyethylene, polypropylene, polystyrene, and polytetrafluoroethylene.

However, the above-mentioned resin materials each have a high linear expansion coefficient, which significantly differs from a linear expansion coefficient of a metal wiring material to be formed on the substrate. Accordingly, there is a problem of, for example, peeling or breakage of wiring due to the difference in linear expansion coefficient.

In order to achieve lowering of the linear expansion coefficient, there are known techniques each involving utilizing an inorganic substance having a low linear expansion coefficient, such as filling with inorganic powder and glass cloth reinforcement. Meanwhile, the inorganic substance generally has a high specific dielectric constant, and hence there is also a problem in that a specific dielectric constant of a material to be obtained is increased.

In view of the foregoing, there is a proposal of a technology for producing a substrate having a low specific dielectric constant and also having a low linear expansion coefficient through use of hollow inorganic particles, which are particles each having a hollow central portion (Patent Literature 1).

### RELATED ART DOCUMENT

### PATENT DOCUMENT

PTL 1: JP-A-HEI6(1994)-119810

### SUMMARY OF INVENTION

However, even when the above-mentioned technology is used, the lowest specific dielectric constant is no lower than about 1.94. Also when any other technology is used, a material having a specific dielectric constant lower than that is extremely difficult to obtain. Therefore, further lowering of the specific dielectric constant has been desired for years.

The present disclosure has been made in view of such circumstances, and provides a material achieving both an excellent low specific dielectric constant and an excellent low linear expansion coefficient, which has heretofore been difficult to obtain.

According to a first embodiment of the present disclosure, there is provided a fluororesin porous body, including : a fluororesin matrix; and hollow inorganic particles dispersed in the fluororesin matrix, in which the fluororesin matrix has a large number of pores.

In addition, according to a second embodiment of the present disclosure, there is provided a metal layer-equipped porous body, including: the fluororesin porous body of the first embodiment; and a metal layer on at least one surface of the fluororesin porous body. According to a third embodiment of the present disclosure, there is provided a wiring substrate, including the metal layer-equipped porous body of the second embodiment, in which the metal layer of the metal layer-equipped porous body is subjected to patterning treatment.

The inventors have focused attention on the long-standing problem, i.e. , that a low specific dielectric constant and a low linear expansion coefficient are in a tradeoff relationship and it is difficult to achieve both a low specific dielectric constant and a low linear expansion coefficient, and have made extensive research with the aim of achieving both a low specific dielectric constant and a low linear expansion coefficient. As a result, the inventors have conceived of controlling the porosity of a material in an organic/inorganic composite technology. The inventors have made further investigations, and as a result, have found that a fluororesin porous body including a fluororesin matrix and hollow inorganic particles, in which the fluororesin matrix has a large number of pores, can achieve both a low specific dielectric constant and a low linear expansion coefficient, which are basically in a tradeoff relationship.

The fluororesin porous body of the present disclosure includes: a fluororesin matrix; and hollow inorganic particles dispersed in the fluororesin matrix, in which the fluororesin matrix has a large number of pores. Therefore, the fluororesin porous body of the present disclosure can achieve both an excellent low specific dielectric constant and an excellent low linear expansion coefficient.

Besides, when the fluororesin porous body has a specific dielectric constant at a frequency of 10 GHz of from 1.6 to 1.9, the precision of a product to be obtained becomes excellent.

In addition, when the fluororesin porous body has a linear expansion coefficient of from 40 ppm/K to 60 ppm/K, the reliability of the product to be obtained becomes excellent.

When the pores of the fluororesin matrix are volatilizationmarks of a volatile additive, industrial productivity becomes excellent.

When the pores of the fluororesin matrix have an average pore diameter of from 10 nm to 1,000 nm, the low specific dielectric constant becomes more excellent.

When the hollow inorganic particles each have a collapse strength of 30 MPa or more, their hollow structures are less liable to be impaired and the low specific dielectric constant becomes even more excellent.

When the fluororesin porous body has a metal layer on at least one surface thereof, the metal layer-equipped porous body serving as a substrate material excellent in low specific dielectric constant and low linear expansion coefficient can be obtained.

When the metal layer of the metal layer-equipped porous body is subjected to patterning treatment, the wiring substrate excellent in reliability can be obtained.

### BRIEF DESCRIPTION OF DRAWINGS

FIG. 1 is a cross-sectional view of a fluororesin porous body according to one embodiment of the present disclosure.
FIG. 2 is a cross-sectional view of a metal layer-equipped porous body according to one embodiment of the present disclosure.
FIG. 3 is a cross-sectional view of a wiring substrate according to one embodiment of the present disclosure.

### DESCRIPTION OF EMBODIMENTS

Embodiments of the present disclosure are hereinafter described in detail. The present disclosure is not limited to these embodiments.

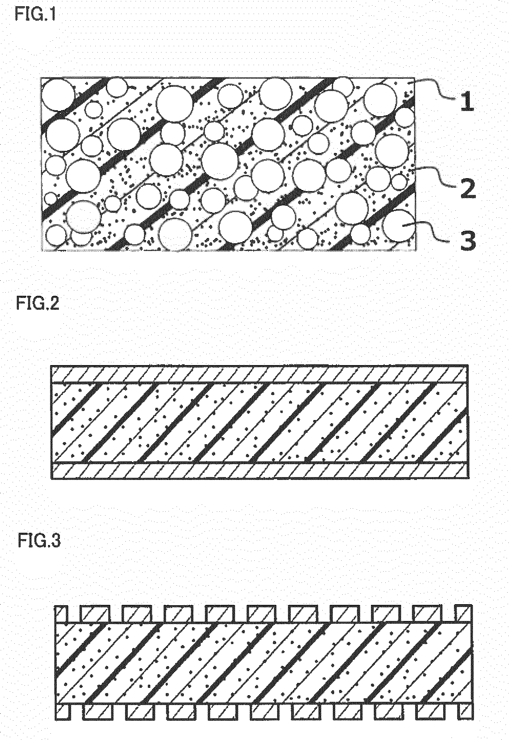

As exemplified in FIG. 1, a fluororesin porous body of the present disclosure includes a fluororesin matrix 1 and hollow inorganic particles 3 dispersed in the fluororesin matrix 1, and the fluororesin matrix 1 has a large number of pores 2. Now, the constituent elements are described one by one.

### <Fluororesin Matrix>

In the present disclosure, a fluororesin for forming the fluororesin matrix is not particularly limited as long as the fluororesin is a resin containing a fluorine atom. However, from the viewpoint of achieving lowering of the specific dielectric constant of the entire system, the specific dielectric constant of the fluororesin at a frequency of 10 GHz is preferably 2.6 or less. Herein, the matrix refers to a base material for holding the hollow inorganic particles in a dispersed state.

Examples of such fluororesin having a specific dielectric constant of 2.6 or less include polytetrafluoroethylene (PTFE), a tetrafluoroethylene-perfluoroalkyl vinyl ether copolymer (PFE), and a tetrafluoroethylene-hexafluoropropylene copolymer (FEP). Those fluororesins maybe used alone or in combination thereof. In addition, the fluororesin may be used as a mixture with another resin to the extent that the specific dielectric constant is not significantly increased.

In addition, the fluororesin has a low affinity for a hydrophilic surface, and hardly provides an adhesive property with the hollow inorganic particles, which are an inorganic substance. Therefore, in order to improve the adhesive property, a fluororesin obtained by modifying part or the whole of a resin may be used.

Herein, as long as the pores are voids present in the fluororesin matrix, the pores may have spherical or amorphous shapes and are not particularly limited. However, it is preferred that the pores preferably include blind holes from the viewpoint of preventing strike-through of an etchant when a metal layer is subjected to patterning treatment by etching in the production of a wiring substrate.

As a method of opening the pores in the fluororesin matrix, there are given, for example, a method involving physically making pores with a laser or the like, and a method involving mixing a volatile additive into the fluororesin and volatilizing the volatile additive to form pores, i.e., a method involving forming pores in the form of volatilization marks of a volatile additive. In particular, a method involving forming pores in the form of volatilization marks of a volatile additive is preferred from the viewpoint of excellence in industrial productivity.

The average pore diameter of the pores is preferably from 10 nm to 1,000 nm, and is more preferably from 50 nm to 500 nm from the viewpoint of keeping the mechanical characteristics of the fluororesin porous body from lowering. The average pore diameter is preferably small because a preventing effect of the following problem can be expected: wiring processing cannot be performed due to infiltration of a plating solution into the fluororesin porous body.

The average pore diameter is determined as follows: the pore diameters of a plurality of pores (100 pores) are determined by direct observation with a scanning electron microscope (SEM) or the like, and the average value thereof is adopted as the average pore diameter.

The volatile additive is preferably a liquid having a property of swelling the fluororesin and having a boiling point of 300°C or less, and examples thereof include polyethylene glycol, an ester, an isoparaffin-based hydrocarbon, and a low-molecular-weight hydrocarbon, such as hexane. In particular, an isoparaffin-based hydrocarbon is preferred. Those volatile additives may be used alone or in combination thereof.

The blending amount of the volatile additive is preferably from 30 parts by weight to 150 parts by weight, more preferably from 80 parts by weight to 120 parts by weight, with respect to 100 parts by weight of the fluororesin. When the blending amount of the volatile additive is too small, there is a tendency that porosity is reduced and the specific dielectric constant is not sufficiently reduced. When the blending amount is too large, there is a tendency that a problem with manufacture arises.

From the viewpoint of the dispersibility of the pores in the matrix, the porosity in the matrix is preferably 5% or more, more preferably 10% or more, particularly preferably 20% or more (generally 90% or less).

### <Hollow Inorganic Particles>

Next, the hollow inorganic particles included in the fluororesin porous body of the present disclosure are described.

The hollow inorganic particles refer to inorganic particles each having a hollow structure in the central portion of the particle and having a low specific dielectric constant. As a material for the hollow inorganic particles, there are given, for example, glass, silica, ceramic, zirconia, and mixtures thereof. Of those, glass is preferred from the viewpoint of a low specific dielectric constant. Those hollow inorganic particles may be used alone or in combination thereof.

The specific dielectric constant of each of the hollow inorganic particles at a frequency of 10 GHz is preferably 1.9 or less, more preferably 1.7 or less. When the specific dielectric constant is too high, there is a tendency that the specific dielectric constant of the porous body to be obtained is increased and a desired low specific dielectric constant is difficult to obtain.

The collapse strength of each of the hollow inorganic particles is preferably 30 MPa or more, more preferably 35 MPa or more, particularly preferably 100 MPa or more. When the collapse strength is too low, there is a tendency that cracking of the hollow inorganic particles occurs during manufacture and the hollow structure is impaired. When the hollow structure is impaired, the specific dielectric constant of the entire system is increased, with the result that a desired specific dielectric constant is not obtained.

Meanwhile, the upper limit of the collapse strength is generally 200 MPa, preferably 190 MPa or less. When the collapse strength is increased, there is a tendency that the thickness of the wall surface of the hollow structure is increased, and hence the amount of air contained in the hollow structure is reduced and a desired low specific dielectric constant is difficult to obtain.

The collapse strength is defined in ASTM D 3102-78, and a pressure at which the volume of the hollow inorganic particles is reduced by 10%, due to their crushing when an appropriate amount of the hollow inorganic particles is placed in glycerin and pressurized, is adopted as the collapse strength.

The median diameter (d50) of the hollow inorganic particles is preferably 10 µm or more from the viewpoint of lowering of the specific dielectric constant. The upper limit of the median diameter is generally 70 µm. When the median diameter is too large, there is a tendency that the hollow structure is liable to be impaired. The median diameter may be measured with a laser diffraction/scattering particle size distribution analyzer.

The amount of an inorganic substance in each of the hollow inorganic particles is preferably from 10 vol.% to 30 vol.% from the viewpoint of lowering of the specific dielectric constant of the material to be obtained, and is more preferably from 15 vol.% to 25 vol.%.

The surfaces of the hollow inorganic particles are preferably subjected to coupling treatment or fluorine treatment in advance from the viewpoint that adhesiveness between the fluororesin and each of the hollow inorganic particles can be enhanced to reduce the linear expansion coefficient.

A coupling agent to be used for the coupling treatment is more preferably a titanium coupling agent, a silane coupling agent, or the like from the viewpoint of easily modifying the surfaces of the hollow inorganic particles, and is particularly preferably a silane coupling agent from the viewpoint of more easily reacting with the hollow inorganic particles. Those coupling agents may be used alone or in combination thereof.

In addition, the fluorine treatment refers to surface treatment of the hollow inorganic particles with a fluororesin of a liquid form, a particle form, or the like. It is preferred that at least one of a chemical interaction and a chemical bond occur between each of the hollow inorganic particles and a fluorine-containing compound.

The hollow inorganic particles may be prepared, but a commercially available product may be utilized. Examples of the hollow inorganic particles that are commercially available include hollow glass microspheres, hollow ceramic microspheres, silica microspheres, and borosilicate microspheres. Of those, hollow glass microspheres and hollow ceramic microspheres are preferred, and hollow glass microspheres are more suitable for use in the present disclosure. Those hollow inorganic particles may be used alone or in combination thereof.

Typical examples of the commercially available product include: "iM16K", "iM30K", "S60HS", and "VS5500" manufactured by 3M; "Corning VYCOR 7930" manufactured by Corning Glass Works; "SI Eccospheres" manufactured by Emerson & Coming; and "GP-7I" manufactured by HarbisonWalker.

The content of the hollow inorganic particles is preferably from 40 vol.% to 80 vol.%, more preferably from 50 vol.% to 70 vol.% of the fluororesin porous body to be obtained. When the content is too small, there is a tendency that the specific dielectric constant is not sufficiently lowered. Meanwhile, when the content is too large, there is a tendency that forming, for example, into a sheet is difficult.

In the present disclosure, the fluororesin porous body of the present disclosure may include an auxiliary component as an optional component to the extent that the physical properties of the fluororesin porous body of the present disclosure are not impaired.

### <Fluororesin Porous Body>

Next, a suitable example of a method of manufacturing the fluororesin porous body of the present disclosure is described.

The method of manufacturing the fluororesin porous body of the present disclosure includes, for example, the steps of:
(I) mixing a composition containing the fluororesin, the hollow inorganic particles, and the volatile additive, to thereby prepare a paste;
(II) roll-forming the paste; and
(III) removing the volatile additive.

By this method, the fluororesin porous body illustrated in FIG. 1, in which, in the fluororesin matrix 1, the hollow inorganic particles 3 are dispersed and the plurality of pores 2 are formed, is obtained.

When the composition containing the fluororesin, the hollow inorganic particles, and the volatile additive is mixed in the preparation of the paste in step (I), it is intended that the composition includes not only a case in which the composition is formed only of the fluororesin, the hollow inorganic particles, and the volatile additive, but also a case in which the fluororesin, the hollow inorganic particles, and the volatile additive are combined with other auxiliary components.

Next, a formed body having a finally intended thickness (e.g., a thickness of from about 0.1 mm to about 2 mm) is produced in step (II), and then the volatile additive is removed in step (III) . Thus, the fluororesin porous body of the present disclosure can be obtained. The removal of the volatile additive in step (III) may be performed in accordance with a method appropriately selected from known methods depending on the volatile additive to be used. Of those, volatilization of the volatile additive by heating of a sheet-like product (sometimes referred to as "film-like product") obtained by rolling is preferred.

In step (III), sintering is preferably performed at a temperature in the firing temperature range of PTFE (e.g., from 300°C to 500°C).

In addition, when a metal layer-equipped porous body is manufactured, the method includes a step (IV) of arranging a metal layer on at least one surface of the fluororesin porous body obtained through steps (I) to (III) (see FIG. 2; in FIG. 2, metal layers are arranged on both upper and lower surfaces of the fluororesin porous body). Further, when a wiring substrate is manufactured, the method includes a step (V) of subjecting the metal layer of the metal layer-equipped porous body to patterning treatment (see FIG. 3).

As step (IV), i.e., the step of arranging a metal layer on at least one surface of the fluororesin porous body, there are given, for example, a method involving bonding a metal foil, such as a copper foil, a method involving laminating a metal foil, and a method involving sputtering or plating the surface with a metal substance. Of those, a lamination method is preferably used from the viewpoint of forming a metal layer having a uniform thickness.

Examples of the metal of the metal layer include gold, silver, platinum, copper, aluminum, and alloys thereof. Of those, copper is preferably used. Those metals may be used alone or in combination thereof. The thickness of the metal layer is preferably from 5 µm to 50 µm.

When the fluororesin porous body is a sheet-like product, the metal layer may be arranged on one surface or both surfaces of the sheet. As a method for the patterning treatment for forming wiring in step (V), there are given an additive method involving using a photoresist or the like and a subtractive method based on etching.

The fluororesin porous body of the present disclosure may be obtained as described above. However, the method of manufacturing the fluororesin porous body is not limited to the foregoing.

The fluororesin porous body of the present disclosure achieves both a satisfactory low specific dielectric constant and a satisfactory low linear expansion coefficient.

Specifically, the specific dielectric constant of the fluororesin porous body at a frequency of 10 GHz is preferably from 1.6 to 1.9 from the viewpoint of the precision of a product to be obtained, and is more preferably 1.85 or less, particularly preferably 1.70 or less. The specific dielectric constant is determined by a cavity resonator perturbation method at a measurement frequency of 10 GHz.

In addition, the linear expansion coefficient of the fluororesin porous body is preferably from 40 ppm/K to 60 ppm/K from the viewpoint of the reliability of the product to be obtained. The linear expansion coefficient is determined as follows : an average linear expansion coefficient in the range of from 30°C to 100°C is adopted as the linear expansion coefficient and determined by a thermal mechanical analysis (TMA) method.

The fluororesin porous body of the present disclosure achieves both a satisfactory low specific dielectric constant and a satisfactory low linear expansion coefficient, and hence a metal layer-equipped porous body including the fluororesin porous body and a metal layer arranged on at least one surface thereof serves as a substrate material excellent in low specific dielectric constant and low linear expansion coefficient.

In addition, a wiring substrate including the metal layer-equipped porous body, in which the metal layer thereof is subjected to patterning treatment, has good precision and is excellent in reliability. Accordingly, the wiring substrate of the present disclosure can be suitably used for a module of a mobile phone, a computer, an antenna, or the like. In addition, the wiring substrate of the present disclosure has a low specific dielectric constant and also has little variation in specific dielectric constant. Accordingly, a detection distance is extended and precision can be improved, and hence the wiring substrate of the present disclosure is suitably used for a wiring substrate for high frequency applications included in a millimeter-wave antenna.

### EXAMPLES

The present disclosure is described in detail below by way of Examples and Comparative Examples. The present disclosure is not limited to these Examples.

First, prior to Examples and Comparative Examples, the following raw material components were prepared.
(1) As a fluororesin, PTFE particles (POLYFLON PTFE F-104 manufactured by Daikin Industries, Ltd.) were prepared.
(2) Hollow Inorganic Particles
   - As hollow inorganic particles a, "Glass Bubbles iM30K" manufactured by 3M (specific dielectric constant: 1.9, collapse strength: 186 MPa) were prepared.
   - As hollow inorganic particles b, "Glass Bubbles iM16K" manufactured by 3M (specific dielectric constant: 1.7, collapse strength: 110 MPa) were prepared.
   - As hollow inorganic particles c, "Glass Bubbles VS5500" manufactured by 3M (specific dielectric constant: 1.5, collapse strength: 38 MPa) were prepared.
   - As hollow inorganic particles d, "Glass Bubbles K1" manufactured by 3M (specific dielectric constant: 1.2, collapse strength: 1.7 MPa) were prepared.
   - As hollow inorganic particles e (for Comparative Example 1), silica microspheres ("SDT-60 Eccospheres" manufactured by Emerson & Coming) were prepared.
(3) As a volatile additive, "Isopar M" manufactured by ExxonMobil Corporation was prepared.

### [Examples 1 to 3, and Comparative Examples 1 and 2]

The above-mentioned raw material components were blended and mixed at a ratio shown in Table 1 below to prepare a porous body composition (paste), the paste was rolled at room temperature (23°C) to form a sheet having a thickness of 150 µm, and the sheet was sintered at 400°C to volatilize the volatile additive. Thus, a sheet-like fluororesin porous body having a plurality of pores (average pore diameter: 100 nm) was produced.

With the use of each sheet thus obtained, characteristic evaluations were performed in accordance with methods to be described below. The results of the evaluations are collectively shown in Table 1 below.

### <Specific Dielectric Constant>

A complex dielectric constant was measured by a cavity resonator perturbation method at a measurement frequency of 10 GHz, and its real part (εr') was adopted as a specific dielectric constant. With the use of a specific dielectric constant-measuring apparatus ("Network Analyzer N5230C" manufactured by Agilent Technologies, and "Cavity Resonator 10 GHz" manufactured by Kanto Electronic Application and Development Inc.), a strip-shaped sample (sample size: 2 mm in width×70 mm in length) was cut out of each sheet and subjected to the measurement.

### <Linear Expansion Coefficient>

An average linear expansion coefficient in a sheet plane direction in the range of from 30°C to 100°C was determined as a linear expansion coefficient (ppm/K) by a TMA method with a thermal mechanical analyzer (manufactured by BRUKER AXS, "TMA4000SA").

**Table 1**

| (vol.%) | | | | | |
|---|---|---|---|---|---|
| | Example 1 | Example 2 | Example 3 | Comparative Example 1 | Comparative Example 2 |
| Fluororesin matrix | 40 | 40 | 40 | 40 | 100 |
| Hollow inorganic particles a | 60 | - | - | - | - |
| Hollow inorganic particles b | - | 60 | - | - | - |
| Hollow inorganic particles c | - | - | 60 | - | - |
| Hollow inorganic particles d | - | - | - | - | - |
| Hollow inorganic particles e | - | - | - | 60 | - |
| Volatile additive | 100 parts by weight | 100 parts by weight | 100 parts by weight | - | - |
| Specific dielectric constant | 1.85 | 1.68 | 1.83 | 1.94 | 2.1 |
| Linear expansion coefficient (ppm/K) | 42 | 49 | 56 | 47 | 150 |

| | | | | | |
|---|---|---|---|---|---|
| *The fluororesin matrix and the hollow inorganic particles are "expressed in vol.%." *The volatile additive is "expressed in parts by weight" with respect to 100 parts by weight of the fluororesin. | | | | | |

It is apparent from the results shown above that each of the products of Examples 1 to 3 is a material achieving both a satisfactory low specific dielectric constant and a satisfactory low linear expansion coefficient. In addition, a metal layer-equipped porous body (substrate) including the sheet that was the fluororesin porous body serving as the product of Example 1 and copper foils (Cu layers) formed on both surfaces thereof was produced, and then the copper foils were subjected to patterning treatment by etching to provide a wiring substrate. The wiring substrate uses the fluororesin porous body achieving both a satisfactory low specific dielectric constant and a satisfactory low linear expansion coefficient, and hence is excellent in reliability. When the wiring substrate was used for a millimeter-wave antenna for a vehicle, the following results were obtained: deviation of the position of wiring did not occur and a detection distance was extended.

In contrast, the product of Comparative Example 1 does not have a large number of pores in the fluororesin matrix, and it is found that even its lowest specific dielectric constant has a limit of 1. 94. Although it has been technically difficult to lower the specific dielectric constant even by 0.01 while keeping a low linear expansion coefficient, it is found that the product of each of the Examples of the present disclosure can lower the specific dielectric constant to about 0.1 or less, and can achieve both an excellent low specific dielectric constant and an excellent low linear expansion coefficient.

The product of Comparative Example 2, which is a sheet of PTFE alone including no hollow inorganic particles, has a low specific dielectric constant, but has an extremely high linear expansion coefficient. Thus, it is found that a low specific dielectric constant and a low linear expansion coefficient are generally in a tradeoff relationship and it is difficult to achieve both.

Although specific modes of the present disclosure have been described in Examples above, Examples are for illustrative purposes only and are not to be construed as limitative. It is intended that various modifications apparent to a person skilled in the art fall within the scope of the present disclosure.

The fluororesin porous body of the present disclosure has both an excellent low specific dielectric constant and an excellent low linear expansion coefficient, and hence is suitable as a wiring substrate material for high frequency applications and can be suitably utilized for a millimeter-wave antenna for a vehicle .

### REFERENCE SIGNS LIST

1 fluororesin matrix
2 pore
3 hollow inorganic particle

## Claims

1. A fluororesin porous body, comprising:
a fluororesin matrix; and
hollow inorganic particles dispersed in the fluororesin matrix,
wherein the fluororesin matrix has a plurality of pores.

2. The fluororesin porous body according to claim 1, wherein the fluororesin porous body has a specific dielectric constant at a frequency of 10 GHz of from 1.6 to 1.9.

3. The fluororesin porous body according to claim 1 or 2, wherein the fluororesin porous body has a linear expansion coefficient of from 40 ppm/K to 60 ppm/K.

4. The fluororesin porous body according to any one of claims 1 to 3, wherein the pores of the fluororesin matrix comprise volatilization marks of a volatile additive.

5. The fluororesin porous body according to any one of claims 1 to 4, wherein the pores of the fluororesin matrix have an average pore diameter of from 10 nm to 1,000 nm.

6. The fluororesin porous body according to any one of claims 1 to 5, wherein the hollow inorganic particles each have a collapse strength of 30 MPa or more.

7. A metal layer-equipped porous body, comprising:
the fluororesin porous body of any one of claims 1 to 6; and
a metal layer on at least one surface of the fluororesin porous body.

8. A wiring substrate, comprising the metal layer-equipped porous body of claim 7, wherein the metal layer of the metal layer-equipped porous body is subjected to patterning treatment.
